# EUROPÄISCHE PATENTSCHRIFT

(11) **EP 3 477 262 B1**
(45) Veröffentlichungstag und Bekanntmachung des Hinweises auf die Patenterteilung: **03.03.2021**
(21) Anmeldenummer: 18202315.0
(22) Anmeldetag: 24.10.2018
(51) Int. Cl.: G01D 4/00, G01R 11/57, G01R 11/58

(54) **VERFAHREN ZUR LASTABHÄNGIGEN VERBRAUCHSERFASSUNG VON UNTERSCHIEDLICHEN STROMQUELLEN IM ENDKUNDENBEREICH**
METHOD FOR THE LOAD DEPENDENT CONSUMPTION DETECTION FOR DIFFERENT POWER SOURCES IN THE END CONSUMER AREA
PROCÉDÉ DE DÉTECTION DE LA CONSOMMATION EN FONCTION DE LA CHARGE DE DIFFÉRENTES SOURCES DE COURANT AUPRÈS DES CLIENTS

(30) Priorität: 24.10.2017 DE 102017009879
(43) Veröffentlichungstag der Anmeldung: 01.05.2019
(73) Patentinhaber: Kleier, Stephan, 45891 Gelsenkirchen (DE)
(72) Erfinder: Kleier, Stephan, 45891 Gelsenkirchen (DE)
(74) Vertreter: Demski, Siegfried

(56) Entgegenhaltungen:
- DE-A1-102015 108 764
- US-A1- 2014 117 758
- Michael Fuhs: "David gegen Goliath", PV-Magazine, 12. September 2016 (2016-09-12), Seiten 1-6, XP055565952, Gefunden im Internet: URL:https://www.pv-magazine.de/2016/09/12/ david-gegen-goliath/ [gefunden am 2019-03-07]

## Beschreibung

Die Erfindung ist so wie in den Ansprüchen definiert und betrifft ein Verfahren zur lastabhängigen Verbrauchserfassung von unterschiedlichen Stromquellen im Endkundenbereich, insbesondere in Mehrfamilienhäusern, umfassend zumindest eine Regeleinheit und mehrere Mehrtarif-Verbrauchszähler für die einzelnen Wohnungen mit zumindest zwei Registern, wobei die Regeleinheit über einen Algorithmus die Aktivierung der Register der Mehrtarif-Verbrauchszähler vornimmt, wobei der Gesamtstrombezug zumindest zweier Stromquellen mit unterschiedlichen Tarifen berücksichtigt wird.

Zur Erfassung des Strombezugs einzelner Eigentümer oder Mietparteien werden von den Stadtwerken Zähler verwendet, die den Strombezug ermitteln, um eine korrekte Abrechnung vornehmen zu können. Soweit der Strombezug für ein Mehrfamilienhaus erfolgt, werden solche Zähler für jede einzelne Wohneinheit verwendet. Zur Erfassung des Strombezugs stehen hierbei einfache Zähler oder Mehrtarif-Verbrauchszähler zur Verfügung. Im Bereich der Erzeugung von Strom aus regenerativen Energiequellen stellt sich hierbei die Frage, wie im Mietwohnungsbereich Mieter an der Energiewende beteiligt werden können.

Viele Hauseigentümer sind dazu übergegangen den Strombedarf nicht nur von Netzbetreibern zu beziehen, sondern zusätzlich einen Strombezug aus einer lokalen Anlage zu beziehen, die sich beispielsweise unmittelbar auf dem Hausdach befinden kann. Nach bisherigen Abrechnungsverfahren wird der Strombezug an allen Verbrauchs- und Zählerschnittstellen erfasst und die Aufteilung nach unterschiedlichen Rechenmodellen vorgenommen. Die Frage, wie der unterschiedliche Strombezug, beispielsweise Strombezug aus einer lokalen Anlage oder Strombezug von einem Netzbetreiber auf die einzelnen Verbraucher beziehungswiese Mietparteien aufgeteilt wird, ist sehr umstritten. Neben den aufwendigen lokalen Erfassungseinheiten sind meistens Datenverbindungen zur Weiterleitung der Verbrauchsdaten erforderlich, um eine korrekte Abrechnung vornehmen zu können. Das ganze Verfahren gestaltet sich somit sehr aufwendig und ist aufgrund der Anwendung mit unterschiedlichen Rechenmodellen nicht frei von Fehlern.

Bekannte Steuerungen ohne Regelung ermitteln den Strombezug von lokalen Stromerzeugern und Netzbetreibern, um hieraus einen anteiligen Prozentwert festzulegen, der dann für eine unbestimmte Zeit für alle angeschlossenen Verbraucher gilt. Hierbei können Probleme in der Form auftreten, dass einzelne Verbraucher kurzfristig durch das Einschalten von Verbrauchsgeräten einen erhöhten Strombezug verursachen und entweder mit einem wesentlich teureren Tarif der Netzbetreiber belastet werden oder im umgekehrten Fall besonders günstigen Strombezug des lokalen Stromerzeugers in Anspruch nehmen können. Ein Nachteil der Steuerung besteht darin, dass diese sich auf schnell ändernde Verhältnisse nur in Zeitabständen einstellen kann und gerade in diesen Zeiten durch festgelegte Prozentwerte, Vor- und Nachteile der jeweiligen Mietparteien entstehen können.

Aus der DE 10 2015 108 764 A1 ist ein System zur Stromtarifsteuerung und Stromversorgung für ein Gebäude bekannt. Dieses System arbeitet vorranging mit einer Tabelle anhand der eine Umschaltung der Mehrtarifzähler erfolgt, wobei die Tabelle davon ausgeht, dass der selbst erzeugte Strom bei 0 %, 0 % bis 50 % oder über 50 % liegt und hierzu jeweils einer von drei Tarifen aktiviert wird.

Der vorliegenden Erfindung liegt daher die Aufgabe zugrunde, ein neues Verfahren zur lastabhängigen Verbrauchserfassung von unterschiedlichen Stromquellen im Endkundenbereich aufzuzeigen, welches eine für alle Endkunden befriedigende Lösung ermöglicht.

Erfindungsgemäß ist zur Lösung der Aufgabenstellung vorgesehen, dass die Regeleinheit einen PI-Regler aufweist, welcher den Gesamtstrom des Mehrfamilienhauses aufgeteilt nach den Stromarten über einen ausgewählten Zeitraum integriert und die Register der Mehrtarif-Verbrauchszähler ansteuert. Weitere vorteilhafte Ausgestaltungen des Verfahrens sind in den Unteransprüchen beschrieben.

Das vorgeschlagene und wesentlich vereinfachte Verfahren zeichnet sich dadurch aus, dass die Regeleinheit über ein Algorithmus die Aktivierung der Register der Mehrtarif-Verbrauchszähler vornimmt, wobei der Gesamtstrombezug zumindest zweier Stromquellen mit unterschiedlichen Tarifen berücksichtigt wird. Im Endverbraucherbereich wird mit bekannten Mehrtarif-Verbrauchszählern gearbeitet, wobei eine Zähleinheit/Register der Mehrtarif-Verbrauchszähler für den lokal erzeugten Strom verwendet wird und eine Zähleinheit/Register für den von einem Netzbetreiber bezogenen Strom. Auf diese Weise besteht die Möglichkeit, eine exakte Trennung des Strombezugs eines Netzbetreibers und eines lokal erzeugten Stromes vornehmen zu können. Wenn beispielsweise bei intensiver Sonneneinstrahlung tagsüber der Strom ausschließlich aus einer lokalen Anlage bezogen wird partizipieren somit sämtliche Verbraucher von der günstigeren lokalen Stromerzeugung. Jede Änderung im Strombezug kann korrekt erfasst und an die Endverbraucher weiter gegeben werden. Hierbei wird durch die Regeleinheit eine Aktivierung des Registers für den Strombezug von lokalen Stromerzeugern oder die Aktivierung des Registers für den Strombezug vom Netzbetreiber des Mehrtarif-Verbrauchszählers vorgenommen. Die Regeleinheit mit dem Algorithmus ermöglichen in vorteilhafter Weise, den Gesamtstrombezug unter den Mietparteien in Abhängigkeit der Strombezugs über einen lokalen Stromerzeuger oder einem Netzbetreiber zu berücksichtigen und gleichzeitig dafür Sorge zu tragen, dass sämtliche Mietparteien von einem günstigeren lokalen Stromerzeuger profitieren, und zwar in einer Weise, sodass sich keiner benachteiligt fühlt.

Die Regeleinheit ermöglicht hierbei eine schnelle Erfassung von auftretenden Änderungen, die einerseits durch die Lichtverhältnisse entstehen können und andererseits durch die Verbraucher selbst, wenn diese den Strombezug erhöhen oder erniedrigen.

Durch eine kontinuierlich arbeitende Regeleinheit kann die Umschaltung lieferabhängig in kurzen Zeitabständen erfolgen und durch das Regelverhalten über einen längeren Zeitraum die Vor- und Nachteile insoweit ausgleichen werden, dass für alle Mietparteien eine gerechte Aufteilung der unterschiedlichen Tarife erfolgt.

Die Regeleinheit ermittelt den Strombezug von einem Netzbetreiber über eine Netzbetreiber-Schnittstelle und den summierten lokalen Stromverbrauch über einen Tarifzähler. Hierbei wird in vorteilhafter Weise durch die Regeleinheit der Strombezug exakt erfasst, um anschließend die tatsächlich anfallenden Kosten für die Endkunden zu ermitteln, wobei der lokale Strombezug aus regenerativen Energiequellen wesentlich günstiger als von einem Netzbetreiber ist und somit entsprechend bei allen Mietparteien berücksichtigt werden kann.

In Ausgestaltung der Erfindung ist vorgesehen, dass die Regeleinheit einen Algorithmus verwendet, um den Gesamtstrombezug der Mehrtarif-Verbrauchszähler aus der Summe des Strombezugs aus einer Netzbetreiber-Schnittstelle und einem Tarifzähler der lokalen Stromerzeugungseinheit zu ermitteln. Hierdurch wird der Gesamtstrombezug von einer lokalen Stromerzeugungseinheit und eines Netzbetreibers erfasst, wobei der Regelalgorithmus ferner vorsieht, dass die Summe der Mehrtarif-Verbrauchszähler für den Strombezug von einem Netzbetreiber der Mehrtarif-Verbrauchszähler und der Strombezug über die Netzbetreiber-Schnittstelle für das Netzregister gleich ist.

Der für den Regelalgorithmus benötigte Gesamtstrombezug der Mehrtarif-Verbrauchszähler wird entweder über ein zusätzlichen Mehrtarif-Verbrauchszähler erfasst oder alternativ rechnerisch in der Regeleinheit aus der Summe der Mehrtarif-Verbrauchszähler für den Strombezug ermittelt oder über die Netzbetreiber-Schnittstelle und den Tarifzähler für lokal erzeugten Strom ermittelt.

Zur Erfassung der Verbrauchswerte sieht die Regeleinheit eine Aktivierung der Register der Mehrtarif-Verbrauchszähler für den Strombezug von lokalen Stromerzeugern oder die Aktivierung des Registers für den Strombezug von Netzbetreibern vor. Durch den Regelalgorithmus kann hierbei sichergestellt werden, dass bei einem erhöhten Strombezug von lokalen Stromerzeugern oder alternativ von Netzbetreibern eine schnelle Reaktion mit Aktivierung der jeweiligen Register erfolgt und somit eine wesentlich genauere Abrechnung möglich ist. Die Regeleinheit verfügt hierbei über eine Schnittstelle, um den ermittelten Strombezug der Mehrtarif-Verbrauchszähler zu erfassen.

Zur Ansteuerung der Register besitzt die Regeleinheit ein PI-Regler, welcher den unterschiedlichen Strombezug (z.B. von einem Netzbetreiber oder lokal erzeugten Strom) des Mehrfamilienhauses über einen ausgewählten Zeitraum integriert und die Register der Mehrtarif-Verbrauchszähler unmittelbar ansteuert. Die Regeleinheit folgt hierbei dem Grundsatz, dass durch fortlaufende Messungen der Strombezugswerte und Vergleichen mit einer Regelgröße eine entsprechende Umschaltung der Register vorgenommen wird. Um die Regelungsaufgabe zu erfüllen muss ein Ist-Wert ermittelt und mit dem Soll-Wert (Regelgröße) verglichen werden, damit bei auftretenden Abweichungen in geeigneter Art und Weise die Register umgeschaltet werden können. Im vorliegenden Fall wird der Strombezug über die Netzbetreiber-Schnittstelle zugrunde gelegt und mithilfe der Regeleinheit sichergestellt, dass die Summe der gemessenen Mehrtarif-Verbrauchszähler und der Strombezug von Netzbetreibern mit den tatsächlichen Verbrauchswerten übereinstimmt. Der PI-Regler zeichnet sich hierbei durch eine schnelle Reaktion und einer exakten Regelung aus, sodass eine genaue Erfassung der Verbrauchswerte gewährleistet werden kann.

Im geschilderten Fall erfolgt die Regelung über den von einem Stromerzeuger bezogenen Strom. Theoretisch besteht ebenso die Möglichkeit, eine Regelung auf Basis des Strombezuges von einer lokalen Stromquelle vorzunehmen, und zwar die Summe der Register der Mehrtarifs-Verbrauchszähler für lokalen Strom. In einem solchen Fall muss aber der Tarifzähler der Netzbetreiber-Schnittstelle ebenfalls berücksichtigt werden. Wichtig ist hierbei, dass immer nur auf die Bilanz einer Bezugsquelle des Stroms geregelt wird, während sich die andere Bezugsquelle automatisch ergibt.

Der Regelalgorithmus basiert konkret auf Basis der Differenz des Strombezugs über die Netzbetreiber-Schnittstelle minus Summe der Mehrtarif-Verbrauchszähler, um die Register zu aktivieren, und zwar wie folgt:
- wenn der Differenzwert größer als eine Regelgröße ist, das Register für den Netzbetreiber und
- wenn der Differenzwert kleiner als eine Regelgröße ist, dass Register für den lokalen Strom, wobei die Regelgröße 1 kWh oder ein mehrfaches hiervon beträgt.

Die Regelgröße kann hierbei 1 kWh aber ebenso 2 oder mehr kWh betragen. Je kleiner die Regelgröße gewählt wird, umso geringer ist der Gesamtfehler durch die Regelung, weil ein auftretender Fehler im Falle einer Regelgröße von 1 kWh bei maximal 2 kWh liegt, aber der Verbrauch wesentlich höher ist und damit dieser auftretende Fehler als äußerst gering angesehen werden kann.

Alternativ besteht die Möglichkeit, dass der Ausgang des PI-Reglers auf null bis 100 Prozent normiert wird und die Register auf Minutenbasis entsprechend des Prozentwertes getaktet werden, und zwar

| | |
|---|---|
| 0% | Register für Netzbetreiber dauerhaft |
| 50% | 30 Sekunden Register für den Netzbetreiber und 30 Sekunden Register für lokalen Strombezug |
| 100% | Register für lokalen Strombezug dauerhaft |

Soweit ein Wert von kleiner oder größer als 50 % mit Ausnahme von null und 100 % vorliegt kann die Taktung entsprechend über 60 Sekunden angepasst werden.

Dieser Regelalgorithmus ist aufwendiger in der Handhabung, sodass bevorzugt der erste Regelalgorithmus verwendet werden kann.

In weiterer Ausgestaltung der Erfindung ist vorgesehen, dass die Regeleinheit über zumindest einen Ausgang, und zwar einen PI-Regler nur die Mehrtarif-Verbrauchszähler oder gleichzeitig sämtliche angeschlossenen Mehrtarif-Verbrauchszähler und Tarifzähler ansteuert. Um die Steuerung so einfach wie möglich zu gestalten, erfasst die Regeleinheit hierbei den Stromverbrauch über die Netzbetreiber-Schnittstelle und steuert über den Ausgang der Regeleinheit, beispielsweise dem vorgenannten PI-Regler gleichzeitig alle angeschlossenen Mehrtarif-Verbrauchszähler, um die Register für den Strombezug vom Netzbetreiber zu aktivieren. Die Ansteuerung der Mehrtarif-Verbrauchszähler und die Übertragung der Werte des Mehrtarif-Verbrauchszählers zur Regeleinheit erfolgt hierbei über technisch bekannte Schnittstellen.

Der gesamte Strombezug eines Mehrfamilienhauses mit verschiedenen Mietparteien wird hierbei von einer lokalen Stromquelle und einer Netzquelle gespeist, wobei der lokale Strom zumindest teilweise zeitabhängig in das Netz eingespeist werden kann.

Das Verfahren zur lastabhängigen Verbrauchserfassung von unterschiedlichen Stromquellen im Endkundenbereich zeichnet sich somit dadurch aus, dass die Regeleinheit in Abhängigkeit der Stromquelle eine Aktivierung der Mehrtarif-Verbrauchszähler vornimmt. Hierbei kann durch die Regeleinheit beispielsweise über einen PI-Regler die Aktivierung eines Registers für den Strombezug von lokalen Stromerzeugern oder die Aktivierung eines Registers für den Strombezug vom Netzbetreiber des Mehrtarif-Verbrauchszählers vornehmen, wodurch eine exakte Erfassung des jeweiligen Verbrauchs erfolgen kann und damit der wesentlich günstigere lokal erzeugte Strom verbrauchsabhängig den Endkunden zugerechnet werden kann. Mithilfe dieses Verfahrens wird somit eine höhere Abrechnungsgenauigkeit erreicht, insbesondere bei der Unterscheidung des Strombezugs von einem Netzbetreiber und von lokal erzeugtem Strom.

Als Regelalgorithmus wird hierbei bevorzugt die Differenz des Strombezugs über die Netzbetreiber-Schnittstelle minus Summe der Mehrtarif-Verbrauchszähler verwendet, wobei das Register der Netzbetreiber dann aktiviert wird, wenn der Differenzwert größer als eine Regelgröße ist, während das Register für den lokalen Strom aktiviert wird, wenn der Differenzwert kleiner als eine Regelgröße ist. Als Regelgröße hat sich hierbei ein Wert von 1 kWh oder gegebenenfalls ein mehrfaches hiervon bewährt.

Die Erfindung wird anhand zweier Blockschaltdiagramme nochmals erläutert.

Es zeigt
- Fig. 1: in einer beispielhaften Ausführung ein Blockschaltdiagramm zur Anwendung des Verfahrens zur lastabhängigen Verbrauchserfassung von unterschiedlichen Stromquellen mit einem Mehrtarif-Verbrauchszähler und
- Fig. 2: in einer beispielhaften Ausführung ein Blockschaltdiagramm ohne Mehrtarif-Verbrauchszähler.

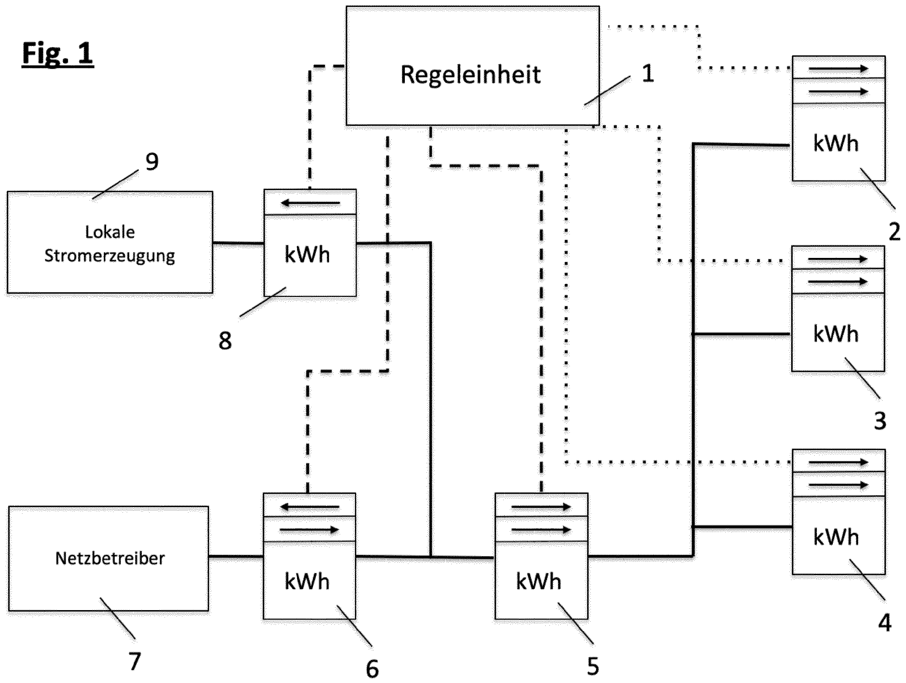

Figur 1 zeigt ein Blockschaltbild zur Erläuterung des Verfahrens zur lastabhängigen Verbrauchserfassung von unterschiedlichen Stromquellen. Eine Regeleinheit 1 ist zur Steuerung der Mehrtarif-Verbrauchszähler 2, 3, 4 vorgesehen, wobei die Mehrtarif-Verbrauchszähler 2, 3, 4 aus Mehrtarif-Verbrauchszählern bestehen. Über einen zusätzlichen Mehrtarif-Verbrauchszähler 2, 3, 4 wird der gesamte Stromverbrauch der Mehrtarif-Verbrauchszähler 2, 3, 4 erfasst. Über eine Netzbetreiber-Schnittstelle 6 wird der von einem Netzbetreiber 7 bezogene Strom erfasst. Über einen Tarifzähler 8 wird der lokal erzeugte Strom einer lokalen Stromerzeugungseinheit 9 ermittelt. Die Mehrtarif-Verbrauchszähler 2, 3, 4 besitzen zumindest zwei Register, damit eine Umschaltung vorgenommen werden kann. Die Umschaltung der Mehrtarif-Verbrauchszähler 2, 3, 4 erfolgt in Abhängigkeit des Strombezuges über die Regeleinheit 1, welche beispielsweise zu diesem Zweck einen PI-Regler aufweist. Der gesamte Strombezug der Mehrtarif-Verbrauchszähler 2, 3, 4 wird hierbei über einen zusätzlichen Mehrtarif-Verbrauchszähler 2, 3, 4 erfasst.

Für den Fall, dass die Verbraucher einen geringen Strombedarf haben, besteht die Möglichkeit den lokal erzeugten Strom unmittelbar in das Netz einzuspeisen und verringert auf diese Weise die Kosten des Netzbetreibers 7.

Zur Ansteuerung der Mehrtarif-Verbrauchszähler 2, 3, 4 und die Übertragung des erfassten Verbrauchs der Mehrtarif-Verbrauchszähler 2, 3, 4 können beispielsweise technisch bekannte Schnittstellen verwendet werden.

Die Besonderheit der vorliegenden Regeleinheit 1 besteht hierbei darin, dass ein Verfahren angewendet werden kann, welches zu einer korrekten Abrechnung des Strombezugs aus unterschiedlichen Stromquellen für den Endkundenbereich führt. Dieses Verfahren 1 ist daher vorzugsweise für Mehrfamilienhäuser vorgesehen.

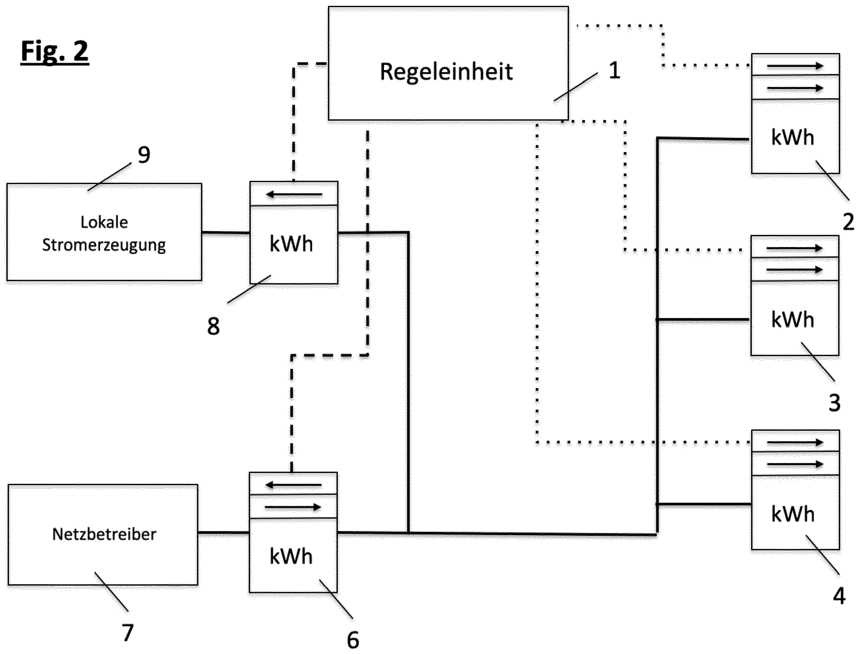

Figur 2 zeigt ein Blockschaltdiagramm zur Erläuterung des Verfahrens ohne einen Mehrtarif-Verbrauchszähler 2, 3, 4. In diesem Fall wird der Strombezug der Mehrtarif-Verbrauchszähler 2, 3, 4 rein rechnerisch in der Regeleinheit 1 aus der Summe der einzelnen Mehrtarif-Verbrauchszähler 2, 3, 4 ermittelt oder alternativ über die Netzbetreiber-Schnittstelle 6 und den Tarifzähler 8 des lokal erzeugten Stromes berechnet.

### Bezugszeichenliste

- 1: Regeleinheit
- 2: Mehrtarif-Verbrauchszähler
- 3: Mehrtarif-Verbrauchszähler
- 4: Mehrtarif-Verbrauchszähler
- 5: Mehrtarif-Verbrauchszähler
- 6: Netzbetreiber-Schnittstelle
- 7: Netzbetreiber
- 8: Tarifzähler
- 9: lokale Stromerzeugungseinheit

## Patentansprüche

1. Verfahren zur lastabhängigen Verbrauchserfassung von unterschiedlichen Stromquellen im Endkundenbereich in einem Mehrfamilienhaus, insbesondere in Mehrfamilienhäusern, umfassend zumindest eine Regeleinheit (1) und mehrere Mehrtarif-Verbrauchszähler (2, 3, 4) für die einzelnen Wohnungen mit zumindest zwei Registern, wobei die Regeleinheit (1) über einen Algorithmus die Aktivierung der Register der Mehrtarif-Verbrauchszähler (2, 3, 4) vornimmt, wobei der Gesamtstrombezug zumindest zweier Stromquellen mit unterschiedlichen Tarifen berücksichtigt wird,
**dadurch gekennzeichnet,**
**dass** die Regeleinheit (1) einen PI-Regler aufweist, welcher den Gesamtstrom des Mehrfamilienhauses aufgeteilt nach den Stromarten über einen ausgewählten Zeitraum integriert und die Register der Mehrtarif-Verbrauchszähler (2, 3, 4) ansteuert.

2. Verfahren nach Anspruch 1,
**dadurch gekennzeichnet,**
**dass** die Regeleinheit (1) den Strombezug eines Netzbetreibers (7) über eine Netzbetreiber-Schnittstelle (6) und den lokalen Strombezug über einen Tarifzähler (8) erfasst.

3. Verfahren nach Anspruch 1 oder 2,
**dadurch gekennzeichnet,**
**dass** die Regeleinheit (1) einen Algorithmus verwendet, sodass der Gesamtstrombezug der Mehrtarif-Verbrauchszähler (2, 3, 4) aus der Summe des Strombezuges und Lieferung aus einer Netzbetreiber-Schnittstelle (6) und einem Tarifzähler (8) der lokalen Stromerzeugungseinheit (9) gebildet wird.

4. Verfahren nach einem der Ansprüche 1, 2 oder 3,
**dadurch gekennzeichnet,**
**dass** der Regelalgorithmus vorsieht, dass die Summe der Mehrtarif-Verbrauchszähler (2, 3, 4) für den Strombezug von einem Netzbetreiber (7) der Mehrtarif-Verbrauchszähler (2, 3, 4) und der Strombezug über die Netzbetreiber-Schnittstelle (6) gleich ist.

5. Verfahren nach einem der Ansprüche 1 bis 4,
**dadurch gekennzeichnet,**
**dass** die Regeleinheit (1) den Strombezug der Mehrtarif-Verbrauchszähler (2, 3, 4) über einen zusätzlichen Mehrtarifzähler (5) erfasst oder rechnerisch in der Regeleinheit (1) die Summe der Mehrtarif-Verbrauchszähler (2, 3, 4) für den Strombezug ermittelt.

6. Verfahren nach einem der Ansprüche 1 bis 5,
**dadurch gekennzeichnet,**
**dass** die Regeleinheit (1) eine Aktivierung der Register der Mehrtarif-Verbrauchszähler (2, 3, 4) für den Strombezug von lokalen Stromerzeugern oder die Aktivierung des Registers für den Strombezug von Netzbetreibern (7) vornimmt.

7. Verfahren nach einem der Ansprüche 1 bis 6,
**dadurch gekennzeichnet,**
**dass** die Regeleinheit (1) über eine Schnittstelle den ermittelten Strombezug getrennt nach Stromarten der Mehrtarif-Verbrauchszähler (2, 3, 4) erfasst.

8. Verfahren nach einem der Ansprüche 1 bis 7,
**dadurch gekennzeichnet,**
**dass** der Regelalgorithmus auf Basis der Differenz:
Strombezug über Netzbetreiber-Schnittstelle (6) minus Summe der Mehrtarif-Verbrauchszähler (2, 3, 4), die Register aktiviert, und zwar
- wenn der Differenzwert größer als eine Regelgröße ist, das Register für den Netzbetreiber und
- wenn der Differenzwert kleiner als eine Regelgröße ist, dass Register für den lokalen Strom,
wobei die Regelgröße 1 kWh oder ein mehrfaches hiervon beträgt.

9. Verfahren nach einem der Ansprüche 1 bis 8,
**dadurch gekennzeichnet**
**dass** der Ausgang des PI-Reglers auf null bis 100 Prozent normiert wird und die Register auf Minutenbasis entsprechend des Prozentwertes
| | |
|---|---|
| 0% | Register für Netzbetreiber dauerhaft |
| 50% | 30 Sekunden Register für den Netzbetreiber und 30 Sekunden Register für lokalen Strombezug |
| 100% | Register für lokalen Strombezug dauerhaft |
getaktet wird.

10. Verfahren nach einem der Ansprüche 1 bis 9,
**dadurch gekennzeichnet**
**dass** die Regeleinheit (1) über zumindest einen Ausgang, und zwar einen PI-Regler nur die Mehrtarif-Verbrauchszähler (2, 3, 4) oder gleichzeitig sämtliche angeschlossenen Mehrtarif-Verbrauchszähler (2, 3, 4) und Tarifzähler (5) ansteuert.

11. Verfahren nach einem der Ansprüche 1 bis 10,
**dadurch gekennzeichnet**
**dass** der Strombezug eines Mehrfamilienhauses von einer lokalen Stromquelle und einer Netzquelle gespeist wird, oder dass der lokale Strom zumindest teilweise zeitabhängig in das Netz eingespeist wird.

## Claims

1. A method for the load-dependent consumption detection of different sources of electricity in the end user region in a multiple dwelling unit, in particular in multiple dwelling units, comprising at least one automatic control unit (1) and a plurality of multi-rate consumption meters (2, 3, 4) for the individual apartments with at least two registers, wherein the automatic control unit (1) performs, via an algorithm, the activation of the registers of the multi-rate consumption meters (2, 3, 4), wherein the total electricity supply of at least two sources of electricity is taken into consideration with different rates,
**characterized in that**
the automatic control unit (1) has an automatic PI-controller which integrates the total electricity of the multiple dwelling unit, split according to the types of electricity, over a selected period and activates the registers of the multi-rate consumption meters (2, 3, 4).

2. Method according to claim 1,
**characterized in that**
the automatic control unit (1) detects the electricity supply of a network provider (7) via a network provider interface (6) and the local electricity supply via a rate meter (8).

3. Method according to claim 1 or 2,
**characterized in that**
the automatic control unit (1) uses an algorithm such that the total electricity supply of the multi-rate consumption meters (2, 3, 4) is formed from the sum of the electricity supply and the supply from a network provider interface (6) and a rate meter (8) of the local electricity generation unit (9).

4. Method according to one of claims 1, 2 or 3,
**characterized in that**
the automatic control algorithm provides that the sum of the multi-rate consumption meters (2, 3, 4) for the electricity supply of a network provider (7) of the multi-rate consumption meters (2, 3, 4) and the electricity supply via the network provider interface (6) are identical.

5. Method according to one of claims 1 to 4,
**characterized in that**
the automatic control unit (1) detects the electricity supply of the multi-rate consumption meters (2, 3, 4) via an additional multi-rate meter (5), or detects the sum of the multi-rate consumption meters (2, 3, 4) for the electricity supply by calculation in the automatic control unit (1).

6. Method according to one of claims 1 to 5,
**characterized in that**
the automatic control unit (1) performs an activation of the registers of the multi-rate consumption meters (2, 3, 4) for the electricity supply from local electricity companies, or the activation of the register for the electricity supply from network providers (7).

7. Method according to one of claims 1 to 6,
**characterized in that**
the automatic control unit (1) detects the determined electricity supply via an interface separated according to types of electricity of the multi-rate consumption meters (2, 3, 4).

8. Method according to one of claims 1 to 7,
**characterized in that**
the automatic control algorithm activates the registers on the basis of the difference:
electricity supply via the network provider interface (6) minus the sum of the multi-rate consumption meters (2, 3, 4), namely
- if the difference value is larger than a controlled variable, the register for the network provider, and
- if the difference value is smaller than a controlled variable, the register for the local electricity,
wherein the controlled variable is 1 kWh or a multiple thereof.

9. Method according to one of claims 1 to 8,
**characterized in that**
the output of the PI controller is set to zero to 100 percent, and the registers are clocked on a minute-basis corresponding to the percent value
| | |
|---|---|
| 0% | registers for network providers, permanently |
| 50 % | 30 seconds registers for the network provider, and 30 seconds registers for the local electricity supply |
| 100% | registers for the local electricity supply, permanently. |

10. Method according to one of claims 1 to 9,
**characterized in that**
the automatic control unit (1) activates, via at least one output, namely a PI-controller, only the multi-rate consumption meters (2, 3, 4), or simultaneously all connected multi-rate consumption meters (2, 3, 4) and rate meters (5).

11. Method according to one of claims 1 to 10,
**characterized in that**
the electricity supply of a multiple dwelling unit is fed from a local source of electricity and a network source, or the local electricity is introduced into the network at least partially in a time-dependent manner.

## Revendications

1. Procédé pour enregistrer la consommation en fonction de la charge de différentes sources de courant au niveau du client final dans un immeuble collectif, en particulier dans des immeubles collectifs, comprenant au moins une unité de régulation (1) et plusieurs compteurs de consommation multi-tarif (2, 3, 4) pour les différents appartements avec au moins deux registres, l'unité de régulation (1) effectuant une activation des registres des compteurs de consommation multi-tarif (2, 3, 4) au moyen d'un algorithme, l'approvisionnement électrique total à partir d'au moins deux sources de courant avec des tarifs différents étant pris en compte,
**caractérisé en ce**
**que** l'unité de régulation (1) présente un régulateur PI qui intègre le courant total de l'immeuble collectif réparti selon les types de courant sur une période de temps sélectionnée et commande les registres des compteurs de consommation multi-tarif (2, 3, 4).

2. Procédé selon la revendication 1,
**caractérisé en ce**
**que** l'unité de régulation (1) enregistre l'approvisionnement électrique à partir d'un opérateur de réseau (7) via une interface d'opérateur de réseau (6) et l'approvisionnement électrique local via un compteur tarifaire (8).

3. Procédé selon la revendication 1 ou 2,
**caractérisé en ce**
**que** l'unité de régulation (1) utilise un algorithme de sorte que l'approvisionnement électrique total des compteurs de consommation multi-tarif (2, 3, 4) est formé de la somme de l'approvisionnement électrique et de la livraison à partir d'une interface d'opérateur de réseau (6) et d'un compteur tarifaire (8) de l'unité de production d'électricité locale (9).

4. Procédé selon l'une des revendications 1, 2 ou 3,
**caractérisé en ce**
**que** l'algorithme de régulation prévoit que la somme des compteurs de consommation multi-tarif (2, 3, 4) pour l'approvisionnement électrique à partir d'un opérateur de réseau (7) des compteurs de consommation multi-tarif (2, 3, 4) et l'approvisionnement électrique via l'interface d'opérateur de réseau (6) soit égale.

5. Procédé selon l'une des revendications 1 à 4,
**caractérisé en ce**
**que** l'unité de régulation (1) enregistre l'approvisionnement électrique des compteurs de consommation multi-tarif (2, 3, 4) via un compteur multi-tarif supplémentaire (5) ou détermine par calcul dans l'unité de régulation (1) la somme des compteurs de consommation multi-tarif (2, 3, 4) pour l'approvisionnement électrique.

6. Procédé selon l'une des revendications 1 à 5,
**caractérisé en ce**
**que** l'unité de régulation (1) effectue une activation des registres des compteurs de consommation multi-tarif (2, 3, 4) pour l'approvisionnement électrique à partir de producteurs d'électricité locaux ou l'activation du registre pour l'approvisionnement électrique à partir d'opérateurs de réseau (7).

7. Procédé selon l'une des revendications 1 à 6,
**caractérisé en ce**
**que** l'unité de commande (1) enregistre, via une interface, l'approvisionnement électrique déterminé de façon séparée selon les types de courant des compteurs de consommation multi-tarif (2, 3, 4).

8. Procédé selon l'une des revendications 1 à 7,
**caractérisé en ce**
**que** l'algorithme de régulation active les registres sur la base de la différence:
approvisionnement électrique via l'interface d'opérateur de réseau (6) moins somme des compteurs de consommation multi-tarif (2, 3, 4), comme suit:
- lorsque la valeur de la différence est supérieure à une grandeur de régulation, le registre de l'opérateur de réseau et,
- lorsque la valeur de la différence est inférieure à une grandeur de régulation, le registre pour le courant local,
la grandeur de régulation étant de 1 kWh ou un multiple de cette valeur.

9. Procédé selon l'une des revendications 1 à 8,
**caractérisé en ce**
**que** la sortie du régulateur PI est normalisée de zéro à 100 % et les registres sont cadencés minute par minute en fonction de la valeur du pourcentage:
| | |
|---|---|
| 0 % | registre pour opérateur de réseau en permanence |
| 50 % | 30 secondes registre pour opérateur de réseau et 30 secondes registre pour approvisionnement électrique local |
| 100% | registre pour approvisionnement électrique local en permanence. |

10. Procédé selon l'une des revendications 1 à 9,
**caractérisé en ce**
**que** l'unité de régulation (1) commande, par l'intermédiaire d'au moins une sortie, à savoir un régulateur PI, seulement les compteurs de consommation multi-tarif (2, 3, 4) ou simultanément tous les compteurs de consommation multi-tarif (2, 3, 4) et compteurs tarifaires (5) raccordés.

11. Procédé selon l'une des revendications 1 à 10,
**caractérisé en ce**
**que** l'approvisionnement électrique d'un immeuble collectif est assuré par une source de courant locale et une source réseau, ou que le courant local est au moins partiellement injecté dans le réseau en fonction du temps.
